# EUROPEAN PATENT SPECIFICATION

(11) **EP 3 619 682 B1**
(45) Date of publication and mention of the grant of the patent: **25.11.2020**
(21) Application number: 18718173.0
(22) Date of filing: 25.04.2018
(51) Int. Cl.: G06T 7/33, G06T 7/73

(54) **A LIGHTING PLAN GENERATOR**
BELEUCHTUNGSPLANGENERATOR
GÉNÉRATEUR DE PLAN D'ÉCLAIRAGE

(30) Priority: 03.05.2017 US 201762500924 P; 18.05.2017 EP 17171809
(43) Date of publication of application: 11.03.2020
(73) Proprietor: Signify Holding B.V., 5656 AE Eindhoven (NL)
(72) Inventor: HEGAZY, Tamir, 5656 AE Eindhoven (NL)
(74) Representative: Verweij, Petronella Daniëlle
(86) International application number: PCT/EP2018/060595
(87) International publication number: WO 2018/202505

(56) References cited:
- WO-A1-2016/169884
- JOHN KASSEBAUM ET AL: "3-D Target-Based Distributed Smart Camera Network Localization", IEEE TRANSACTIONS ON IMAGE PROCESSING, IEEE SERVICE CENTER, PISCATAWAY, NJ, US, vol. 19, no. 10, 1 October 2010 (2010-10-01), pages 2530-2539, XP011328625, ISSN: 1057-7149, DOI: 10.1109/TIP.2010.2062032
- WAN DINGRUI ET AL: "Stereo vision using two PTZ cameras", COMPUTER VISION AND IMAGE UNDERSTANDING, vol. 112, no. 2, 7 March 2008 (2008-03-07) , pages 184-194, XP028857056, ISSN: 1077-3142, DOI: 10.1016/J.CVIU.2008.02.005
- Rahul Raman: "Study on Models for Smart Surveillance through Multi-Camera Networks", , 1 November 2013 (2013-11-01), XP055419569, Retrieved from the Internet: URL:http://ethesis.nitrkl.ac.in/5643/1/Fin al_Thesis.pdf [retrieved on 2017-10-26]
- S Mohamed ET AL: "Corresponding Author: Pan Correction through Overlap Estimation in a Multi-Camera Environment", Journal of Computer Science, 1 January 2010 (2010-01-01), pages 985-993, XP055419709, Retrieved from the Internet: URL:https://pdfs.semanticscholar.org/c7d0/ 0fcfcc1619e134b2178c3416e4c3f34e4447.pdf

## Description

### TECHNICAL FIELD

The present disclosure relates to a lighting plan generator system and method for generation of a lighting plan based on combining images or image data. Particularly the present disclosure relates to a lighting plan generator system and method for generating a lighting plan based on combining the image data by aligning and matching portions of the images. The present disclosure relates to the use of such generated lighting plans for inspection purposes or commissioning purposes.

### BACKGROUND

Generating a lighting plan for a large area installation is a useful operation for many reasons.

Monitoring or managing a large areas or spaces filled with many light units benefits from an accurately determined lighting plan. For example, for commissioning purposes the lighting plan may be checked against the installation plan to determine whether all of the light units have been correctly installed.

Commissioning is a quality assurance process that ensures installed building systems perform interactively and continuously according to owner needs and the design intent. It begins with identifying owner project requirements and ends with ensuring the design intent, finished design and installed systems satisfy these requirements.

In the lighting industry, the term "commissioning" is often applied to lighting control system activation, or factory startup, in which a manufacturer representative calibrates installed controls as a service. It may also be used to describe functional testing.

Commissioning applies to the entire building and its energy-using systems, including lighting and controls. System activation and functional testing are steps within a larger process of ensuring all installed systems satisfy the design intent and owner requirements. Commissioning connected lighting systems is very labor-intensive as it requires a lot of foot work accessing each light fixture, possibly multiple times. The commissioning is also prone to error. Verification and error correction makes the process even more costly. One of the most (if not the most) important steps in commissioning of connected lighting systems is generating a lighting plan or fixture mapping because it feeds fixture grouping and configuration. Cost/time-Efficient and accurate fixture mapping is crucial to a successful commissioning job.

Attempts to automate the fixture mapping process to achieve time and cost efficiency as well as accuracy have been made. Some approaches exploit the fixture-embedded photo sensors, while others rely on the RF signal strength. Although they have the potential to save the time and cost of the commissioning process, the drawback of such methods is that they require an accurate floor/ceiling plan as an input, whose availability is not guaranteed.

It also known to use multi-camera networks for surveillance, pan correction through overlap estimation and 3-D target-based distributed camera network localization. See John Kassebaum et al.: "3-D Target-Based Distributed Smart Camera Network Localization", IEEE Transactions on Image Processing, IEEE Service Center, Piscataway, NJ, US, vol. 19, no. 10, 1 October 2010, pages 2530-2539, XP011328625; Rahul Raman: "Study on Models for Smart Surveillance through Multi-Camera Networks", 1 November 2013, XP055419529; S Mohamed et al.: "Corresponding Author: Pan Correction through Overlap Estimation in a Multi-Camera Environment", Journal of Computer Science, 1 January 2010, pages 985-993, XP055419709.

### SUMMARY

The following provides a system and method for providing a lighting system plan or lighting plan. The system and method includes a processing unit configured to receive multiple overlapping images (floor, wall, etc.) of the environment from a plurality of light units in a space. Orientation sensor information, derived independent from the images, from each light unit is also received from each light unit to provide light unit orientation. The data from the light units (e.g. compass information and images) are combined. The combination of data from the images is achieved by aligning or rotating the images, using the orientation sensor information, to form a blended image and based on spatial information (e.g. distance between fixtures, camera field of view, and ceiling height), determine an estimation of the overlap of the fields of view among the images to determine light units from the blended image. The overlapping image portions can then be extracted to form an array, which are labeled with a light unit ID. The overlapping image portions (e.g. side portions) can be cropped. The labeled portions with light unit IDs are used to identify neighboring light units by using an image comparison algorithm to match overlapping image portions that indicate neighboring light units. A lighting plan is then generated with the light unit mapping/ceiling plan with the physical light unit IDs mapped thereon. In addition to light unit or fixture mapping, more applications can be realized, such as auto floor plan generation, zone detection, and layout change detection.

According to one aspect disclosed herein, there is provided a lighting plan generator configured to generate a lighting plan from overlapping images, the lighting plan comprising a map of locations of a plurality of light units located on a ceiling of an interior space, and the lighting plan generator comprising: processing unit configured to receive at least two images and orientation sensor information from respective light units in the space, the at least two images comprising at least partially overlapping areas; align the at least two images based on the orientation sensor information, and matching the overlapping areas to combine the at least two images, wherein the combined image form the lighting plan.

In such a manner the generation of the lighting plan may be performed based on receiving image data in the form of bitmap or other image data formats, aligning the images in a common orientation, processing the images to produce images with common features or overlapping image portions and then stitching or combining these together based on these common features/ overlapping image portions identified in the images in order that the combined image may then produce a lighting plan. Importantly, with the use of the digital orientation sensor to determine the orientation of the light units and hence the orientation of the captured images, the computational complexity of the image matching algorithm is greatly reduced.

The term "light unit" should be understood to refer to any one or more of a variety of radiation sources, including, but not limited to, LED-based sources (e.g., various semiconductor-based structures that emit light in response to current, light emitting polymers, organic light emitting diodes (OLEDs), electroluminescent strips, and the like), incandescent sources (e.g., filament lamps, halogen lamps), fluorescent sources, phosphorescent sources, high-intensity discharge sources (e.g., sodium vapor, mercury vapor, and metal halide lamps), lasers, other types of electroluminescent sources, pyro-luminescent sources (e.g., flames), candle-luminescent sources (e.g., gas mantles, carbon arc radiation sources), photo-luminescent sources (e.g., gaseous discharge sources), cathode luminescent sources using electronic satiation, galvano-luminescent sources, crystallo-luminescent sources, kine-luminescent sources, thermo-luminescent sources, triboluminescent sources, sonoluminescent sources, radio luminescent sources, and luminescent polymers.

The term "Luminaire" or "lighting unit" or "fixture" is used herein to refer to an implementation or arrangement of one or more lighting units in a particular form factor, assembly, or package. The term "lighting unit" is used herein to refer to an apparatus including one or more light sources of same or different types. A given lighting unit may have any one of a variety of mounting arrangements for the light source(s), enclosure/housing arrangements and shapes, and/or electrical and mechanical connection configurations. Additionally, a given lighting unit optionally may be associated with (e.g., include, be coupled to and/or packaged together with) various other components (e.g., control circuitry) relating to the operation of the light source(s). An "LED-based lighting unit" refers to a lighting unit that includes one or more LED-based light sources, alone or in combination with other non-LED-based light sources.

The term "processor" is one which employs one or more microprocessors that may be programmed using software (e.g., microcode) to perform various functions discussed herein. A processor may be implemented as a combination of dedicated hardware to perform some functions (e.g., one or more programmed microprocessors and associated circuitry) to perform other functions. For example, the light units 100 may perform all or some the processing in combination with the processing unit 106. Examples of processor components that may be employed in various embodiments of the present disclosure include, but are not limited to, conventional microprocessors, application specific integrated circuits (ASICs), and field-programmable gate arrays (FPGAs).

In various implementations, a processor or controller may be associated with one or more storage media (generically referred to herein as "memory," e.g., volatile and non-volatile computer memory such as RAM, PROM, EPROM, and EEPROM, floppy disks, compact disks, optical disks, magnetic tape, etc.). In some implementations, the storage media may be encoded with one or more programs that, when executed on one or more processors and/or controllers, perform at least some of the functions discussed herein. Various storage media may be fixed within a processor or controller or may be transportable, such that the one or more programs stored thereon can be loaded into a processor or controller so as to implement various aspects of the present invention discussed herein. The terms "program" or "computer program" are used herein in a generic sense to refer to any type of computer code (e.g., software or microcode) that can be employed to program one or more processors or controllers.

In one network implementation, one or more devices coupled to a network may serve as a controller for one or more other devices coupled to the network (e.g., in a master/slave relationship). In another implementation, a networked environment may include one or more dedicated controllers that are configured to control one or more of the devices coupled to the network. Generally, multiple devices coupled to the network each may have access to data that is present on the communication medium or media; however, a given device may be "addressable" in that it is configured to selectively exchange data with (i.e., receive data from and/or transmit data to) the network, based, for example, on one or more particular identifiers (e.g., "addresses") assigned to it.

The term "network" as used herein refers to any interconnection of two or more devices (including controllers or processors) that facilitates the transport of information (e.g. for device control, data storage, data exchange, etc.) between any two or more devices and/or among multiple devices coupled to the network. As should be readily appreciated, various implementations of networks suitable for interconnecting multiple devices may include any of a variety of network topologies and employ any of a variety of communication protocols. Additionally, in various networks according to the present disclosure, any one connection between two devices may represent a dedicated connection between the two systems, or alternatively a non-dedicated connection. In addition to carrying information intended for the two devices, such a non-dedicated connection may carry information not necessarily intended for either of the two devices (e.g., an open network connection). Furthermore, it should be readily appreciated that various networks of devices as discussed herein may employ one or more wireless, wire/cable, and/or fiber optic links to facilitate information transport throughout the network.

It should be appreciated that all combinations of the foregoing concepts and additional concepts discussed in greater detail below (provided such concepts are not mutually inconsistent) are contemplated as being part of the inventive subject matter disclosed herein. In particular, all combinations of claimed subject matter appearing at the end of this disclosure are contemplated as being part of the inventive subject matter disclosed herein.

The following are descriptions of illustrative embodiments that when taken in conjunction with the following drawings will demonstrate the above noted features and advantages, as well as further ones. In the following description, for purposes of explanation rather than limitation, illustrative details are set forth such as architecture, interfaces, techniques, element attributes, etc. However, it will be apparent to those of ordinary skill in the art that other embodiments that depart from these details would still be understood to be within the scope of the appended claims. Moreover, for the purpose of clarity, detailed descriptions of well-known devices, circuits, tools, techniques, and methods are omitted so as not to obscure the description of the present system. It should be expressly understood that the drawings are included for illustrative purposes and do not represent the scope of the present system. In the accompanying drawings, like reference numbers in different drawings may designate similar elements. Also, the drawing figures are not necessarily to scale, emphasis instead generally being placed upon illustrating the principles of the invention.

### BRIEF DESCRIPTION OF THE DRAWINGS

To assist understanding of the present disclosure and to show how embodiments may be put into effect, reference will be made by way of example to the accompanying drawings in which:
Fig. 1A is a schematic block diagram of a lighting plan generating system according to some embodiments,
Fig. 1B is a schematic block diagram of a light unit according to the embodiment of Fig. 1A,
Fig. 2 is a diagram of overlapping images received from the light units of the system of Fig. 1,
Fig. 3 shows a flow diagram of a first lighting plan generation method implementing the lighting plan generator as shown in Fig. 1.

### DETAILED DESCRIPTION OF EMBODIMENTS

The concept implemented in the embodiments described herein is configured to generate a lighting plan for an interior space within which is located a lighting system comprising light units located on a surface (typically the ceiling) for providing illumination for the interior space. The generated lighting plan may then be employed within a range of various applications such as, for example, lighting system commissioning, lighting system inspection, and lighting system location estimation.

The lighting plan may comprise light unit location or position information relative to a defined datum or data. The defined datum or data may be a structural element of the interior space and the location or position information is 'absolute' location or position information. In some embodiments the defined datum or data may be other light units and the location or position information is 'relative' location or position information.

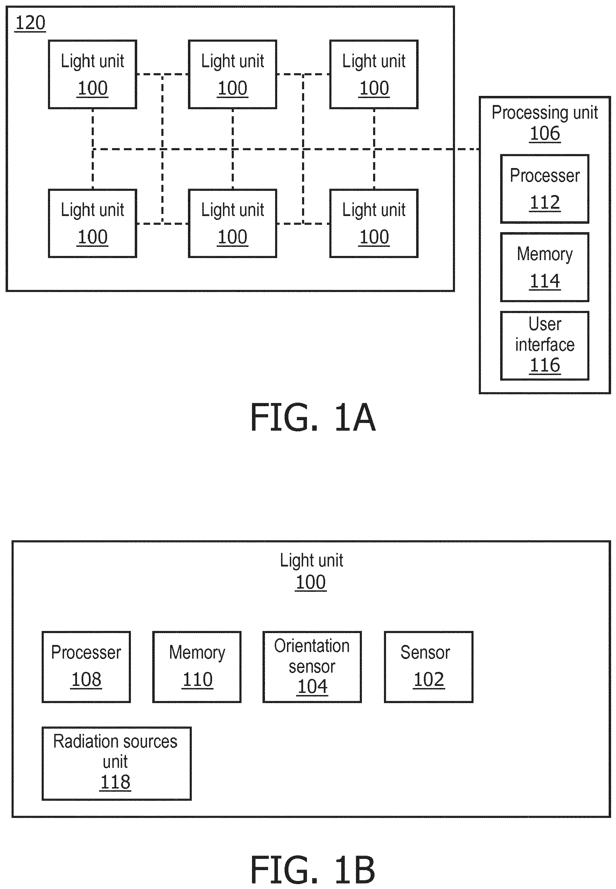

With respect to Figure 1A example apparatus for generating a lighting plan according to an embodiment are shown. In Figure 1A the lighting plan generating system comprises a plurality of light units 100 in a space 120 and a processing unit or server 106 configured communicate with each of the plurality of light units 100. Processing unit 106 is further configured to receive and process image data and orientation sensor information, derived independent from the images, from the plurality of light units 100.The apparatus does not process or localize the image data to determine position or orientation of light unit 100. The lights units 100 are interconnected to commutate with each other and/or the processing unit 106 to form a network of connected lighting units.

As shown in Figure IB, each light unit 100 has a sensor 102, for example a camera, an orientation sensor 104, for example a digital compass, and radiation sources 118. Each light unit 100 may also include a processer 108, a memory 110.

The sensor 102, for example a camera, hereinafter camera 102, is configured to capture images of the environment or space within which the light unit 100 is operating. Typically, the camera 102 is orientated such that the images captured are overlapping images of the floor of the interior space. However in some embodiments the camera 110 may be configured to capture images of any surface on which the light units 100 are employed. The camera 102 may be any suitable camera or imaging array. In some embodiments the camera 102 may be configured to further determine a depth or distance from the camera to the surface. For example in some embodiments the camera 102 is a stereoscopic image determiner configured to determine a depth or distance based on comparing the parallax differences.

The orientation sensor (e.g., digital compass) 104 is configured to provide directional or orientation information (without the need to process images from sensor 102 (e.g. camera images) that is used to commonly align the captured images and be used in the processing of the overlapping images. In some embodiments, the orientation sensor may provide not only the horizontal orientation but also the "pitch"/"roll" angles of the light unit.

The light units 100 may further comprise a processor 108 and memory 110. The processor 108 can in some embodiments be configured to execute various program codes. The implemented program codes in some embodiments comprise image capture control, image processing, and image encoding.

The light units 100 may further comprise memory 110. The implemented program codes can in some embodiments be stored for example in the memory 110 for retrieval by the processor 108 whenever needed. The memory 110 could further provide a section for storing data, for example image data in accordance with the application as described herein.

The light units 100 may further comprise a transmitter (or a transceiver), not shown.

The light units 100 may thus be in wired or wireless communication with the processing unit 106 (or interconnected via a hard wire) and each other. The transmitter (or transceiver) may communicate with other apparatus by any suitable known communications protocol. For example in some embodiments the transmitter can use a suitable universal mobile telecommunications system (UMTS) protocol, a wireless local area network (WLAN) protocol such as for example IEEE 802.X, or a suitable short-range radio frequency communication protocol such as Bluetooth.

In the following embodiment the light units 100 are configured to provide to the processing unit 106 a series of overlapping images which cover the floor of the interior for which the lighting map is being generated. In such embodiments light units' camera 102 is configured to capture the images, which can be encoded using the processor 108 and passed to the processing unit 106. The orientation sensor 104 is configured to pass orientation information to the processor and these /orientation information may be attached to the images to also be transmitted to the processing unit 106.

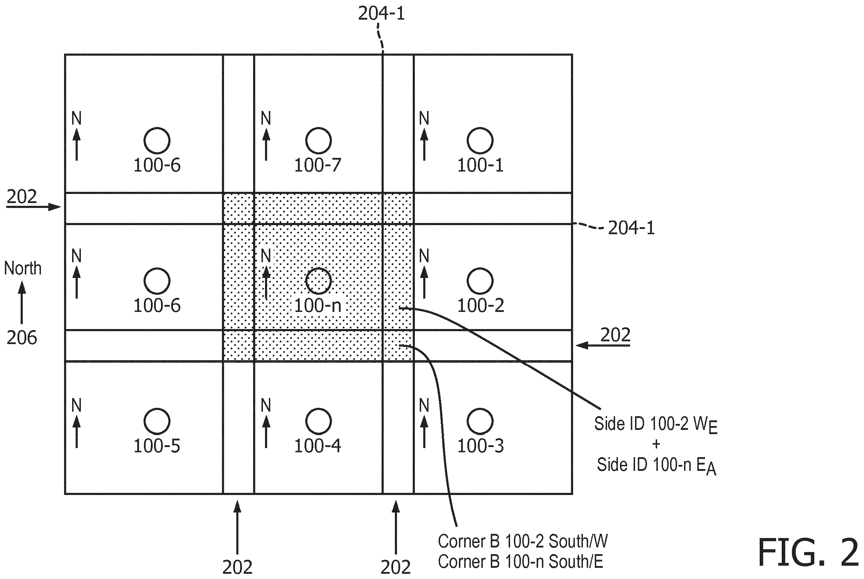

Figure 2 is a diagram of (the aligned) overlapping images received from the light units of the system of Fig. 1. The light units 100-1 to 100-n of an interior space capture overlapping images. The light units 100-1 to 100-n are represented by circles. The light units 100 are shown at various positions within the interior space. Each light unit's camera 110 is configured to capture the respective images 204-1 to 204-n of which each image 204 has an overlap 202 at least partially with one other image. For example image 204-1 is shown by box indicated by the dotted lines. As shown in Fig. 2, each of the received images 204 are rotated or aligned in a common orientation or direction (for example, "North").

The processing unit 106 may comprise a receiver (or transceiver) or wired to each of the light unit 100. The processing unit 106 is configured to receive the overlapping images captured by the light units 100. The receiver (or transceiver) may communicate with other apparatus by any suitable known communications protocol. For example in some embodiments the receiver can use a suitable universal mobile telecommunications system (UMTS) protocol, a wireless local area network (WLAN) protocol such as for example IEEE 802.X, or a suitable short-range radio frequency communication protocol such as Bluetooth.

The processing unit 106 may further comprise a processor at 112 and memory 114. The processor 114 can in some embodiments be configured to execute various program codes. The implemented program codes in some embodiments comprise image processing, lighting map generation, commissioning report generation using the generated lighting map, and inspection report generation using the generated lighting map.

The processing unit may further comprising memory 114. The implemented program codes can in some embodiments be stored for example in the memory 114 for retrieval by the processor 112 whenever needed. The memory 114 could further provide a section for storing data, for example image data in accordance with the application as described herein.

The processing unit 106 a further comprise a user interface 106.

The user interface (UI) 106 may enable a user to input commands to the processing unit 106. The user interface 116 may be a keypad or other suitable input device.

The processing unit 106 may further comprise a display (not shown). The display is configured to present information. In some embodiments a touch screen may provide both user interface 116 input and display output functions.

In some embodiments the processing unit's 106 processer 112 further comprises an image combiner algorithm, image overlapping algorithm and an image comparison algorithm. The image combiner algorithm may be configured to receive the images from the light units 100 and combine or blend the images to form a single combined or blended image. As described further below, the image overlapping algorithm extracts potentially overlapping image portions and labels them with an image portion ID. The image overlapping algorithm uses commissioning information (distance between fixtures, camera field of view, and ceiling height), determine an estimation of the overlap of the fields of view among different cameras. The image comparison algorithm determines matching overlapping portion 202 of each image 204, by using, for example, image recognition.

In some embodiments the processing units' 106 processor 112 may further comprises a lighting plan determiner. The lighting plan determiner may be configured to determine and/or retrieve a previously determined lighting plan. The processor 112 may be configured to compare the previous information with the current light plan. The output can then be passed to a report generator.

In some embodiments the processing unit 106 comprises a report generator. The report generator may be configured to receive the output of the lighting plan and further be configured to generate a report based on the differences between the lighting plans.

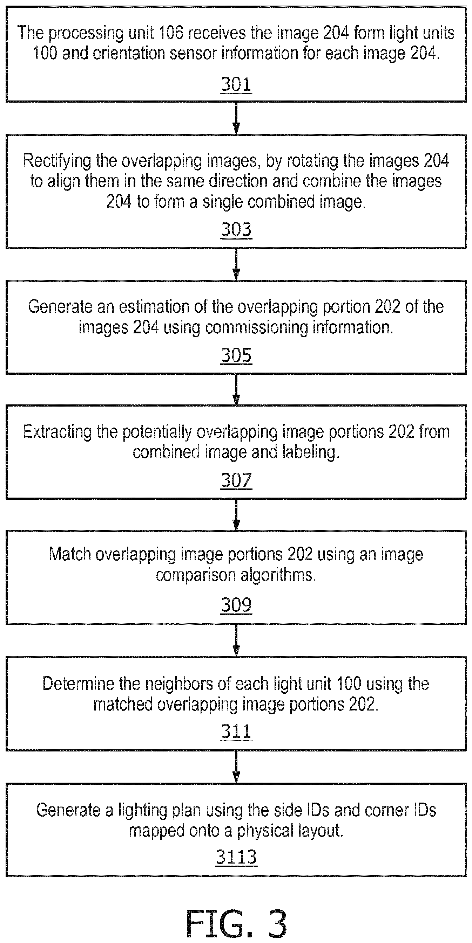

With respect to Figure 3 an example flow diagram of the operation of the processing unit 106 as shown in Figure 1 is shown.

The processing unit 106 is configured to receive the overlapping images 204 from the light units 100. The overlapping images 204 may be received on an ongoing or sequential basis wherein the images are uploaded to the processing unit 106 as the light units 100 captures images. In some embodiments the overlapping images 204 may be received as a batch process, wherein one or more of the light units 100 are configured to collect and upload the multiple images or all of the light units at the same time.

The operation of receiving the overlapping images is shown in Figure 3 by step 301.

The processing unit 106 receives the images 204-1 to 204-n and respective orientation sensor information 208 from light unit's 100-1 to 100-n. Processing unit's 108 of light units 100 may also perform a portion of the processing, noted below.

The operation of rectifying the overlapping images is shown in Figure 3 by step 303. The received images 204-1 to 204-n are then rotated so that they are all aligned in the same direction and combined or blended to form a single combined image by the processor 112.

With respect to Figure 2 an example of the rotated and combining of the images 204-1 to 204-n is shown. As shown in Figure 2, each received image 204-1 to 204-n are rotated such that each are aligned in the correct direction/orientation sensor information 206, using the received orientation sensor information 208. For example, in a common direction, e.g. "North" as shown in Fig. 2 and more particularly, to align the images in the direction they were taken so that overlapping portions can be discovered.

The operation of the generating an estimation of the overlapping portion 202 of the images 204 is determined using commissioning information guidelines, e.g., fixture spacing standards/guidelines, camera field of view, and ceiling height. The distances need not be fully accurate because they only provide an initial search range for the image comparison algorithm, which will determine the accurate spacing. This is shown in Figure 3 by step 305.

The operation of extracting the potentially overlapping image portions 202 from combined image is shown in Figure 3 by step 307. Each overlapping image portions 202 is labeled (and may put into an array not shown) with a light unit ID and side ID or corner ID. For example, as shown in Figure 2, Light unit 100-2 has a light unit ID of light unit ID "100-2" and has side ID of "side ID 100-2 East" and a corner ID of "Corner ID East/South". Each overlapping portion 202 can then be cropped from the combined image. Each light unit 100 and overlapping portions 202 are accordingly labeled.

The operation of finding the matching overlapping image portions 202 using an image comparison algorithms is shown in Figure 3 by step 309. The matched overlapping image portions 202 indicate neighboring a light unit 100. For example, light unit 100-2 and light unit 100-n have matching overlapping image portions of side ID 100-2 West and side ID 100-n East; and corner ID 100-2 South/West and corner ID 100-n South/East.

The operation of determining neighbors of each light unit 100 is shown in Figure 3 by step 311. Neighbors of each light unit 100 are determined using the match overlapping image portions 202 and the side IDs and corner IDs.

Then a lighting plan report may be generated, for example by the report generator, based the side IDs and corner IDs mapped onto a physical layout.

The operation of generating the lighting plan report is shown in Figure 3 by step 313.

The lighting plan generator may be implemented within a lighting system commissioning system wherein the determined light unit plan is compared against the installation lighting plan to determine whether the light units have been installed correctly. The overlapping images may be received on an ongoing or sequential basis wherein the images are uploaded to the processing unit 106.

In some embodiments of the processing unit 106 further comprises an image rectifier. The image rectifier may be configured to receive the overlapping images and process each image to compensate for camera lens and/or orientation errors such that data within the images may be combined. The image rectifier may for example be configured to identify the shooting angle or the pose angle of the camera. Following the determination of the shooting angle of the image the image rectifier may then be configured to process the image based on the shooting angle to form a rectified image. The image rectifier 106 may furthermore scale the image such that each image is uniformly scaled. For example the output of the image rectifier may be such that each image each image the images may be analyzed and the resultant analysis output directly compared.

The camera lens errors or other non-linear features (and the compensation) may be determined by comparing a sequence of images and using identified features within the images comparing distances or angles between the features. For example any distances or angles between features which differ between images (which have been rectified and scaled to compensate for the differences in camera orientation) may be registered and used to generate a mapping or scaling to compensate for the differences. In other words the position of the features may be triangulated from the images, with the camera lens errors or other non-linear features appearing as differences between the triangulated positions and the individual image position.

While the inventive embodiments have been described and illustrated herein, those of ordinary skill in the art will readily envision a variety of other means and/or structures for performing the function and/or obtaining the results and/or one or more of the advantages described herein, and each of such variations and/or modifications is deemed to be within the scope of the inventive embodiments described herein. More generally, those skilled in the art will readily appreciate that all parameters, dimensions, materials, and configurations described herein are meant to be exemplary and that the actual parameters, dimensions, materials, and/or configurations will depend upon the specific application or applications for which the inventive teachings is/are used. Those skilled in the art will recognize, or be able to ascertain using no more than routine experimentation, many equivalents to the specific inventive embodiments described herein. It is, therefore, to be understood that the foregoing embodiments are presented by way of example only and that the invention is defined by the appended claims. Inventive embodiments of the present disclosure are directed to each individual feature, system, article, material, kit, and/or method described herein. In addition, any combination of two or more such features, systems, articles, materials, kits, and/or methods, if such features, systems, articles, materials, kits, and/or methods are not mutually inconsistent, is included within the inventive scope of the present disclosure.

All definitions, as defined and used herein, should be understood to control over dictionary definitions, definitions in documents incorporated by reference, and/or ordinary meanings of the defined terms.

The indefinite articles "a" and "an," as used herein in the specification and in the claims, unless clearly indicated to the contrary, should be understood to mean "at least one."

The phrase "and/or," as used herein in the specification and in the claims, should be understood to mean "either or both" of the elements so conjoined, i.e., elements that are conjunctively present in some cases and disjunctively present in other cases. Multiple elements listed with "and/or" should be construed in the same fashion, i.e., "one or more" of the elements so conjoined. Other elements may optionally be present other than the elements specifically identified by the "and/or" clause, whether related or unrelated to those elements specifically identified. Thus, as a non-limiting example, a reference to "A and/or B", when used in conjunction with open-ended language such as "comprising" can refer, in one embodiment, to A only (optionally including elements other than B); in another embodiment, to B only (optionally including elements other than A); in yet another embodiment, to both A and B (optionally including other elements); etc.

As used herein in the specification and in the claims, "or" should be understood to have the same meaning as "and/or" as defined above. For example, when separating items in a list, "or" or "and/or" shall be interpreted as being inclusive, i.e., the inclusion of at least one, but also including more than one, of a number or list of elements, and, optionally, additional unlisted items. Only terms clearly indicated to the contrary, such as "only one of' or "exactly one of," or, when used in the claims, "consisting of," will refer to the inclusion of exactly one element of a number or list of elements. In general, the term "or" as used herein shall only be interpreted as indicating exclusive alternatives (i.e. "one or the other but not both") when preceded by terms of exclusivity, such as "either," "one of," "only one of," or "exactly one of." "Consisting essentially of," when used in the claims, shall have its ordinary meaning as used in the field of patent law.

As used herein in the specification and in the claims, the phrase "at least one," in reference to a list of one or more elements, should be understood to mean at least one element selected from any one or more of the elements in the list of elements, but not necessarily including at least one of each and every element specifically listed within the list of elements and not excluding any combinations of elements in the list of elements. This definition also allows that elements may optionally be present other than the elements specifically identified within the list of elements to which the phrase "at least one" refers, whether related or unrelated to those elements specifically identified. Thus, as a non-limiting example, "at least one of A and B" (or, equivalently, "at least one of A or B," or, equivalently "at least one of A and/or B") can refer, in one embodiment, to at least one, optionally including more than one, A, with no B present (and optionally including elements other than B); in another embodiment, to at least one, optionally including more than one, B, with no A present (and optionally including elements other than A); in yet another embodiment, to at least one, optionally including more than one, A, and at least one, optionally including more than one, B (and optionally including other elements); etc.

It should also be understood that, unless clearly indicated to the contrary, in any methods claimed herein that include more than one step or act, the order of the steps or acts of the method is not necessarily limited to the order in which the steps or acts of the method are recited.

In the claims, as well as in the specification above, all transitional phrases such as "comprising," "including," "carrying," "having," "containing," "involving," "holding," "composed of," and the like are to be understood to be open-ended, i.e., to mean including but not limited to. Only the transitional phrases "consisting of' and "consisting essentially of' shall be closed or semi-closed transitional phrases, respectively.

## Claims

1. A lighting plan generator configured to generate a lighting plan from images (202), the lighting plan comprising a map of locations of a plurality of light units (100) located in a space (120), the lighting plan generator comprising:
at least two of the plurality of light units (100) including a sensor (102) to capture the images (202) and an orientation sensor (104) to provide orientation information, independent from the images, for the images (202);
a processing unit (106) configured to,
- receive the at least two images from the plurality of light units (100), the at least two images (204) comprising at least partially overlapping areas (202) captured by respective sensors (102) in said interior space and orientation sensor information (206) for each of the at least two images;
- align the received at least two images (204) to a common direction using the orientation sensor (104) information (206),
- determine overlapping image portions (202) of the at least two images (204),
- generate the lighting plan using the determined overlapping image portions (202).

2. The lighting plan generator as claimed in claim 1, wherein the processing unit rotates the received at least two images (204) to align them to the common direction.

3. The lighting plan generator as claimed in claim 1, wherein the processing unit (106) is further configured to combine the aligned at least two images (204) to generate a merged image, using the overlapping image portions (202).

4. The lighting plan generator (199) as claimed in claim 3, wherein the processing unit (106) is further configured to determine neighbors of each light unit (100) using the overlapping image portions (202).

5. The lighting plan generator (199) as claimed in claim 3, wherein the processing unit (106) is further configured to generate an estimation of the overlapping image portions (202) using commissioning information.

6. The lighting plan generator (199) as claimed in claim 1, wherein the processing unit (106) is further configured to:
receive an installation lighting plan;
compare the installation lighting plan with the generated lighting plan; and
generate a commissioning report based on the comparison of the installation lighting plan with the generated lighting plan.

7. A non-transitory computer-readable storage medium comprising instructions which, when executed by a computer, cause the computer to carry out the steps of the method of claim 8.

8. A method of generating a lighting plan from overlapping images, the lighting plan comprising a map of locations of a plurality of light units (100) located in a space (120), the method comprising:
in processing unit (106),
receiving at least two images from the plurality of light units (100), the at least two images (204) comprising at least partially overlapping areas (202) captured by respective of light units (100) in said space and orientation information (206), independent from the images (202), for each of the at least two images (202);
aligning the received at least two images (204) to a common direction using the orientation information (206),
determining overlapping image portions (202) of the at least two images (204),
generating the lighting plan using the determined overlapping image portions (202).

9. The method of generating a lighting plan as claimed in claim 8, wherein the step of aligning includes rotating the received at least two images (204) to align them to the common direction.

10. The method of generating a lighting plan as claimed in claim 8, further including the step of combining the aligned at least two images (204) to generate a merged image, using the overlapping image portions (202).

11. The method of generating a lighting plan as claimed in claim 8, further including the step of determining neighbors of each light unit (100) using the overlapping image portions (202).

12. The method of generating a lighting plan as claimed in claim 8, further including the step of generating an estimation of the overlapping image portions (202) using commissioning information.

## Patentansprüche

1. Beleuchtungsplangenerator, der so konfiguriert ist, dass er einen Beleuchtungsplan aus Bildern (202) generiert, wobei der Beleuchtungsplan eine Karte zu Positionen einer Vielzahl von in einem Raum (120) platzierten Lichteinheiten (100) umfasst, wobei der Beleuchtungsplangenerator umfasst:
mindestens zwei der Vielzahl von Lichteinheiten (100) mit einem Sensor (102) zum Erfassen der Bilder (202) sowie einem Orientierungssensor (104), um, unabhängig von den Bildern, Orientierungsinformationen für die Bilder (202) bereitzustellen;
eine Verarbeitungseinheit (106), die so konfiguriert ist, dass sie:
- die mindestens zwei Bilder aus der Vielzahl von Lichteinheiten (100) empfängt, wobei die mindestens zwei Bilder (204) zumindest zum Teil überlappende Bereiche (202), die von jeweiligen Sensoren (102) in diesem inneren Raum erfasst wurden, sowie Orientierungssensorinformationen (206) für jedes der mindestens zwei Bilder, umfassen;
- die empfangenen mindestens zwei Bilder (204) unter Verwendung der Informationen des Orientierungssensors (104) zu einer gemeinsamen Richtung ausrichtet,
- sich überlappende Bildabschnitte (202) der mindestens zwei Bilder (204) ermittelt,
- den Beleuchtungsplan unter Verwendung der ermittelten, sich überlappenden Bildabschnitte (202) generiert.

2. Beleuchtungsplangenerator nach Anspruch 1, wobei die Verarbeitungseinheit die empfangenen mindestens zwei Bilder (204) dreht, um diese zu der gemeinsamen Richtung auszurichten.

3. Beleuchtungsplangenerator nach Anspruch 1, wobei die Verarbeitungseinheit (106) weiterhin so konfiguriert ist, dass sie die ausgerichteten, mindestens zwei Bilder (204) kombiniert, um unter Verwendung der sich überlappenden Bildabschnitte (202) ein verschmolzenes Bild zu generieren.

4. Beleuchtungsplangenerator (199) nach Anspruch 3, wobei die Verarbeitungseinheit (106) weiterhin so konfiguriert ist, dass sie unter Verwendung der sich überlappenden Bildabschnitte (202) Nachbarn jeder Lichteinheit (100) ermittelt.

5. Beleuchtungsplangenerator (199) nach Anspruch 3, wobei die Verarbeitungseinheit (106) weiterhin so konfiguriert ist, dass sie unter Anwendung von Inbetriebnahmeinformationen eine Schätzung der sich überlappenden Bildabschnitte (202) generiert.

6. Beleuchtungsplangenerator (199) nach Anspruch 1, wobei die Verarbeitungseinheit (106) weiterhin so konfiguriert ist, dass sie:
einen Installationsbeleuchtungsplan empfängt;
den Installationsbeleuchtungsplan mit dem generierten Beleuchtungsplan vergleicht; und
aufgrund des Vergleichs des Installationsbeleuchtungsplans mit dem generierten Beleuchtungsplan einen Inbetriebnahmebericht generiert.

7. Nichttransitorisches, computerlesbares Speichermedium mit Instruktionen, die bei Ausführung durch einen Computer den Computer veranlassen, die Schritte des Verfahrens nach Anspruch 8 auszuführen.

8. Verfahren zum Generieren eines Beleuchtungsplans aus sich überlappenden Bildern, wobei der Beleuchtungsplan eine Karte zu Positionen einer Vielzahl von in einem Raum (120) platzierten Lichteinheiten (100) umfasst, wobei das Verfahren beinhaltet, dass:
in Verarbeitungseinheit (106)
mindestens zwei Bilder aus der Vielzahl von Lichteinheiten (100) empfangen werden, wobei die mindestens zwei Bilder (204) zumindest zum Teil überlappende Bereiche (202), welche von jeweiligen Lichteinheiten (100) in diesem Raum erfasst wurden, sowie, unabhängig von den Bildern (202), Orientierungsinformationen (206) für jedes der mindestens zwei Bilder (202) umfassen;
die empfangenen mindestens zwei Bilder (204) unter Verwendung der Orientierungsinformationen (206) zu einer gemeinsamen Richtung ausgerichtet werden,
- sich überlappende Bildabschnitte (202) der mindestens zwei Bilder (204) ermittelt werden,
- der Beleuchtungsplan unter Verwendung der ermittelten, sich überlappenden Bildabschnitte (202) generiert wird.

9. Verfahren zum Generieren eines Beleuchtungsplans nach Anspruch 8, wobei der Schritt des Ausrichtens das Drehen der empfangenen mindestens zwei Bilder (204) umfasst, um sie zu der gemeinsamen Richtung auszurichten.

10. Verfahren zum Generieren eines Beleuchtungsplans nach Anspruch 8, weiterhin umfassend den Schritt des Kombinierens der ausgerichteten, mindestens zwei Bilder (204), um unter Verwendung der sich überlappenden Bildabschnitte (202) ein verschmolzenes Bild zu generieren.

11. Verfahren zum Generieren eines Beleuchtungsplans nach Anspruch 8, weiterhin umfassend den Schritt des Ermittelns von Nachbarn jeder Lichteinheit (100) unter Verwendung der sich überlappenden Bildabschnitte (202).

12. Verfahren zum Generieren eines Beleuchtungsplans nach Anspruch 8, weiterhin umfassend den Schritt des Generierens einer Schätzung der sich überlappenden Bildabschnitte (202) unter Verwendung von Inbetriebnahmeinformationen.

## Revendications

1. Générateur de plan d'éclairage configuré pour générer un plan d'éclairage à partir d'images (202), le plan d'éclairage comprenant une carte d'emplacements d'une pluralité d'unités de lumière (100) situées dans un espace (120), le générateur de plan d'éclairage comprenant :
au moins deux de la pluralité d'unités de lumière (100) incluant un capteur (102) pour capturer les images (202) et un capteur d'orientation (104) pour fournir des informations d'orientation, indépendantes des images, pour les images (202) ;
une unité de traitement (106) configurée pour
- recevoir les au moins deux images à partir de la pluralité d'unités de lumière (100), les au moins deux images (204) comprenant des zones se chevauchant au moins partiellement (202) capturées par des capteurs (102) respectifs dans ledit espace intérieur et des informations de capteur d'orientation (206) pour chacune des au moins deux images ;
- aligner les au moins deux images (204) reçues sur une direction commune en utilisant les informations (206) de capteur d'orientation (104),
- déterminer des portions d'image se chevauchant (202) des au moins deux images (204),
- générer le plan d'éclairage en utilisant les portions d'image se chevauchant (202) déterminées.

2. Générateur de plan d'éclairage selon la revendication 1, dans lequel l'unité de traitement fait tourner les au moins deux images (204) reçues pour les aligner sur la direction commune.

3. Générateur de plan d'éclairage selon la revendication 1, dans lequel l'unité de traitement (106) est configurée en outre pour combiner les au moins deux images (204) alignées pour générer une image fusionnée, en utilisant les portions d'image se chevauchant (202).

4. Générateur de plan d'éclairage (199) selon la revendication 3, dans lequel l'unité de traitement (106) est configurée en outre pour déterminer des voisines de chaque unité de lumière (100) en utilisant les portions d'image se chevauchant (202).

5. Générateur de plan d'éclairage (199) selon la revendication 3, dans lequel l'unité de traitement (106) est configurée en outre pour générer une estimation des portions d'image se chevauchant (202) en utilisant des informations de mise en service.

6. Générateur de plan d'éclairage (199) selon la revendication 1, dans lequel l'unité de traitement (106) est configurée en outre pour :
recevoir un plan d'éclairage d'installation ;
comparer le plan d'éclairage d'installation avec le plan d'éclairage généré ; et
générer un rapport de mise en service sur la base de la comparaison du plan d'éclairage d'installation avec le plan d'éclairage généré.

7. Support de stockage lisible par ordinateur non transitoire comprenant des instructions qui, quand elles sont exécutées par un ordinateur, amènent l'ordinateur à exécuter les étapes du procédé selon la revendication 8.

8. Procédé de génération d'un plan d'éclairage à partir d'images se chevauchant, le plan d'éclairage comprenant une carte d'emplacements d'une pluralité d'unités de lumière (100) situées dans un espace (120), le procédé comprenant :
dans une unité de traitement (106),
la réception d'au moins deux images à partir de la pluralité d'unités de lumière (100), les au moins deux images (204) comprenant des zones se chevauchant au moins partiellement (202) capturées par des unités de lumière (100) respectives dans ledit espace et des informations d'orientation (206), indépendantes des images (202), pour chacune des au moins deux images (202) ;
l'alignement des au moins deux images (204) reçues sur une direction commune en utilisant les informations d'orientation (206),
la détermination de portions d'image se chevauchant (202) des au moins deux images (204),
la génération du plan d'éclairage en utilisant les portions d'image se chevauchant (202) déterminées.

9. Procédé de génération d'un plan d'éclairage selon la revendication 8, dans lequel l'étape d'alignement comprend la rotation des au moins deux images (204) reçues pour les aligner sur la direction commune.

10. Procédé de génération d'un plan d'éclairage selon la revendication 8, incluant en outre l'étape de combinaison des au moins deux images (204) alignées pour générer une image fusionnée, en utilisant les portions d'image se chevauchant (202).

11. Procédé de génération d'un plan d'éclairage selon la revendication 8, incluant en outre l'étape de détermination de voisines de chaque unité de lumière (100) en utilisant les portions d'image se chevauchant (202).

12. Procédé de génération d'un plan d'éclairage selon la revendication 8, incluant en outre l'étape de génération d'une estimation des portions d'image se chevauchant (202) en utilisant des informations de mise en service.
